# Europäisches Patentamt

## European Patent Office

## Office européen des brevets

(19)

(11) Veröffentlichungsnummer: **0 066 050**
**B1**

(12) # EUROPÄISCHE PATENTSCHRIFT

(45) Veröffentlichungstag der Patentschrift:
24.06.87

(51) Int. Cl.⁴: **H 03 K 19/177, G 11 C 17/00**

(21) Anmeldenummer: **82102403.1**

(22) Anmeldetag: **23.03.82**

(54) **Programmierbare logische hochintegrierte Schaltungsanordnung.**

(30) Priorität: **30.05.81 DE 3121562**

(43) Veröffentlichungstag der Anmeldung:
**08.12.82 Patentblatt 82/49**

(45) Bekanntmachung des Hinweises auf die Patenterteilung:
**24.06.87 Patentblatt 87/26**

(84) Benannte Vertragsstaaten:
**DE FR GB**

(56) Entgegenhaltungen:
**US - A - 4 177 452**
**US - A - 4 208 728**

**IBM TECHNICAL DISCLOSURE BULLETIN, Band 20, Nr. 10, März 1978, Seiten 4016-4018, New York, US, P.S. BALASUBRAMANIAN u.a.: "Increasing chip density by space sharing of programmed logic-arrays"**
**IBM TECHNICAL DISCLOSURE BULLETIN, Band 24, Nr. 2, Juli 1981, Seiten 886-887, New York, US, V. GOETZE u.a.: "Three-dimensional programmable logic array"**

(73) Patentinhaber: **IBM DEUTSCHLAND GMBH, Pascalstrasse 100, D-7000 Stuttgart 80 (DE)**
(84) Benannte Vertragsstaaten: **DE**

(73) Patentinhaber: **International Business Machines Corporation, Old Orchard Road, Armonk, N.Y. 10504 (US)**
(84) Benannte Vertragsstaaten: **FR GB**

(72) Erfinder: **Götze, Volkmar, Dipl.-Ing., Malteserstrasse 69, D-7031 Grafenau 2 (DE)**
Erfinder: **Potz, Günther, Dipl.-Ing., Amselweg 21, D-7032 Sindeifingen (DE)**

(74) Vertreter: **Rudolph, Wolfgang, Dipl.-Ing., IBM Deutschland GmbH Schönaicher Strasse 220, D-7030 Böblingen (DE)**

EP 0 066 050 B1

**Beschreibung**

Die Erfindung betrifft eine programmierbare, hoch integrierte, logische Schaltungsanordnung (PLA) nach dem Oberbegriff des Patentanspruchs 1.

Derartige programmierbare, hoch integrierte, logische Schaltungsanordnungen sind grundsätzlich bekannt, so z.B. aus dem Buch «MOS/LSI Design and Application» von W. Carr und J. Mice, McGraw-Hill, 1972, Seiten 229 bis 258. Mit Hilfe derartiger programmierbarer, logischer Schaltungsanordnungen ist die direkte Implementierung kombinatorischer Logik in regelmässigen Strukturen, insbesondere Matrixanordnungen möglich, wodurch sich gegenüber den nicht in regelmässigen Strukturen zusammengeschalteten logischen Verknüpfungsschaltungen der Vorteil ergibt, dass sich sowohl die Massenherstellung als auch das Testen und die Lagerhaltung wesentlich vereinfachen. Neben den programmierbaren, logischen Anordnungen, deren Informationsinhalt bereits während des Herstellungsvorgangs fest eingeprägt wird und danach nicht mehr zu ändern ist, sind auch solche programmierbare, logische Anordnungen bekannt geworden, die eine Programmierung auch nach dem Herstellungsprozess erlauben. Als Beispiel für eine derartige Anordnung sei auf die US-PS 3 987 286 hingewiesen.

Auch Mehrfachpersonalisierungen mit besonderen Koppel- und Verknüpfungselementen sind bekannt, die mehrere Zustände einnehmen können. Hierzu wird auf das IBM TDB Vol. 17, Nr. 3, August 1974, Seiten 811 und 812 verwiesen. Derartige Lösungen sind jedoch wegen der benötigten Sonderbauelemente, wegen der hohen Redundanz der Bauelemente und wegen der geringen Operationsgeschwindigkeit in der Praxis nicht eingesetzt worden.

Aus dem IBM TDB, Vol. 20, Nr. 10, März 1978, Seiten 4016 bis 4018 und der US-PS 4 084 152 ist eine programmierbare, hoch integrierte, logische Schaltungsanordnung (PLA) bekannt geworden, die zur Erhöhung des Ausnutzungsgrades, der im UND- und im ODER-Feld vorhandenen Verknüpfungszellen zwischen zwei ausführbaren logischen Funktionen umschaltbar ist. Die Verknüpfungszellen beider Felder bestehen aus Feldeffekt-Transistoren, die an den Kreuzungspunkten von Funktionseingangs- und Produkttermleitungen im UND-Feld bzw. Produktterm- und Summentermleitungen im ODER-Feld angeordnet sind. Dabei sind sowohl in dem ODER- als auch in dem UND-Feld Steuerleitungen zur Funktionsumschaltung angeordnet. Durch diese Veröffentlichung ist bereits eine Lösung bekanntgeworden, bei der verbleibende ungenutzte Verknüpfungsbereiche in den genannten Feldern, d.h. redundante Schaltkreise verringert werden. Diese Schaltungsanordnungen haben jedoch den Nachteil, dass sie erhebliche Einschränkungen hinsichtlich des Freiheitsgrads bei der Auslegung komplexer Verknüpfungsnetzwerke aufweisen. Damit geht der an sich erforderliche hohe Grad an Flexibilität bei regelmässigen Strukturen wieder verloren, so dass auch der Einsatz dieser programmierbaren, logischen Anordnungen in der Praxis nur äusserst beschränkt möglich ist.

In der älteren, aber nicht vorveröffentlichten europäischen Patentanmeldung 0 051 693 ist deshalb eine weitere Verbesserung dieser programmierbaren, logischen Anordnungen in hoch integrierter Technik aufgezeigt worden, die höhere Funktionsdichten sowie eine schnelle elektrische Umschaltung zwischen unterschiedlichen Funktionen erlaubt und keine hohen Umprogrammierungsspannungen oder Sonderbauelemente erfordert. Diese Anordnung ist dadurch gekennzeichnet, dass die Koppelelemente Feldeffekttransistoren mit mindestens zwei nebeneinander vorsehbaren Gate-Abschnitten sind, wobei ein Leitendwerden der zugehörigen Source-Drain-Schaltstrecke erst ermöglicht wird, wenn an mindestens den beiden Gate-Abschnitten die zugehörigen Einschaltpotentiale vorliegen, und dass diese mindestens beiden umschaltbaren Funktionen in der Weise eingeprägt werden, dass bei einer nur im Rahmen einer der beiden oder mehreren Funktionen herzustellenden Verbindung einer der Gate-Abschnitte mit der für die Funktionsauswahl massgeblichen Steuerleitung und der mindestens eine verbleibende Gate-Abschnitt eines solchen Koppelelementes mit der betreffenden Eingangsleitung verbunden wird, und dass bei ihm im Rahmen der mindestens beiden Funktionen herzustellenden Verbindungen, die mindestens beiden Gate-Abschnitte eines solchen Koppelelements gemeinsam an die betreffende Eingangsleitung angeschlossen sind. Obwohl sich eine derartige Anordnung durch eine sehr gute Flächennutzung auszeichnet und deshalb für hochintegrierte Bauweise geeignet ist, bleibt jedoch der alte Nachteil immer noch bestehen, dass der redundante Anteil von Bauelementen zu hoch ist.

Der Erfindung liegt deshalb die Aufgabe zugrunde, eine programmierbare, hochintegrierte, logische Schaltungsanordnung (PLA) zu schaffen, die zur Erhöhung des Ausnutzungsgrades der im UND- und ODER-Feld vorhandenen Verknüpfungszellen umschaltbar ist und eine weitere Aktivierung von redundanten Schaltkreisen ermöglicht.

Die erfindungsgemässe Lösung ergibt sich aus dem Kennzeichen des Patentanspruchs 1. Weitere Ausgestaltungen der Erfindung sind in den Patentansprüchen 2 bis 5 charakterisiert.

Durch die Aktivierung des normalerweise ungenutzten Zustands (Don't Care) der Zellen innerhalb der programmierbaren, hoch integrierten, logischen Schaltungsanordnung und durch die separate Ansteuermöglichkeit des UND- und des ODER-Bereichs der programmierbaren, logischen Anordnung ist eine hohe Anzahl von logischen Funktionen bei drastischer Verringerung der Redundanz an Schaltkreisen ermöglicht worden.

Während bei der Lösung nach dem zweitgenannten IBM-TDB ein zusätzlicher Transistor und ein Eingang vorhanden ist, sind bei der lösungsgemässen Schaltungsanordnung die Kontrolleitungen durch äussere Steuerschaltungen zu Funktionsleitungen umgestaltet worden. Dadurch werden nicht nur wie bei der bekanntgewordenen Schaltungsanordnung zwei Funktionsebenen, sondern drei Funktionsebenen bei zwei Gates pro Feldeffekt-Transistor geschaffen.

Durch die eingeführte Steuerschaltung in Form einer zweistufigen UND/ODER-Schaltung ist eine elegante Ansteuerung der UND- und ODER-Bereiche ermöglicht worden, da sich eine derartige Steuerschaltung sehr gut in die gesamte Struktur der programmierbaren logischen Anordnung in hoch integrierter Technik einfügt. Der zusätzliche, für die Steuerlogik erforderliche Platzbedarf kann somit äusserst gering gehalten werden.

Die Erfindung wird nun anhand von in der Zeichnung dargestellten Ausführungsbeispielen näher erläutert.

Es zeigen:

Fig. 1 ein Blockschaltbild einer programmierbaren logischen Anordnung mit dazwischenliegenden Steuerschaltungen,

Fig. 2 ein spezielles Ausführungsbeispiel in Feldeffekt-Transistortechnik mit zwei Gate-Elektroden pro Feldeffekttransistor,

Fig. 3 eine Zelle einer programmierbaren logischen Anordnung mit Aktivierung des Don't Care-Zustands und

Fig. 4 die Funktionsdarstellungsweise in einer zweifach adressierbaren programmierbaren logischen Anordnung mit drei Funktionen.

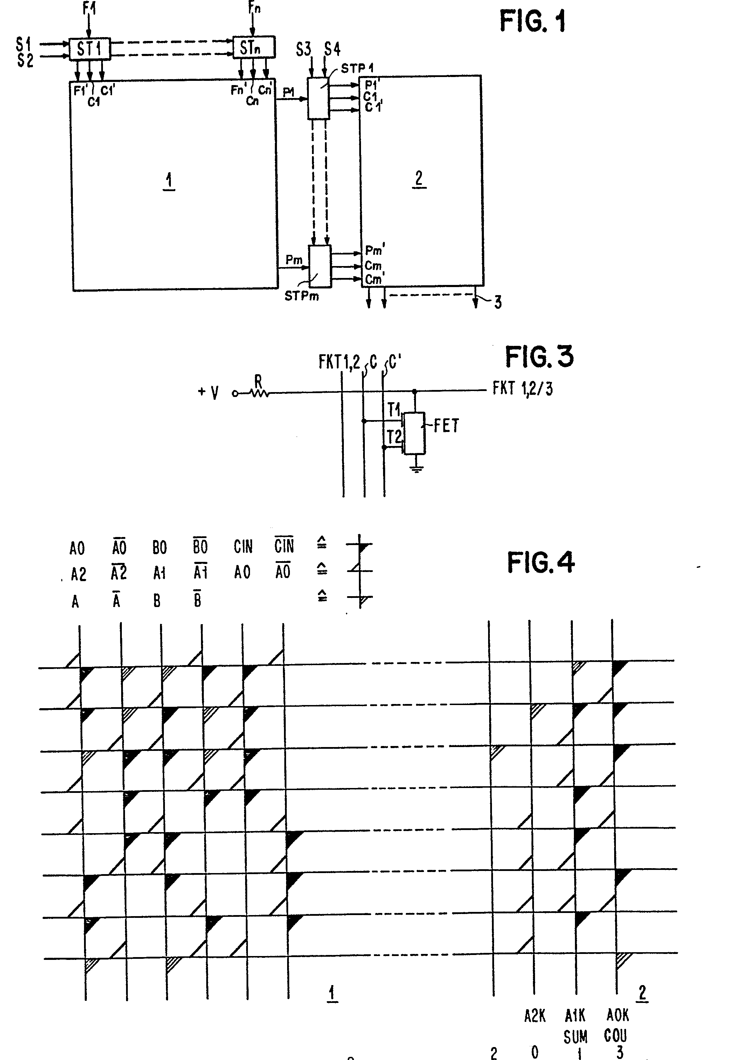

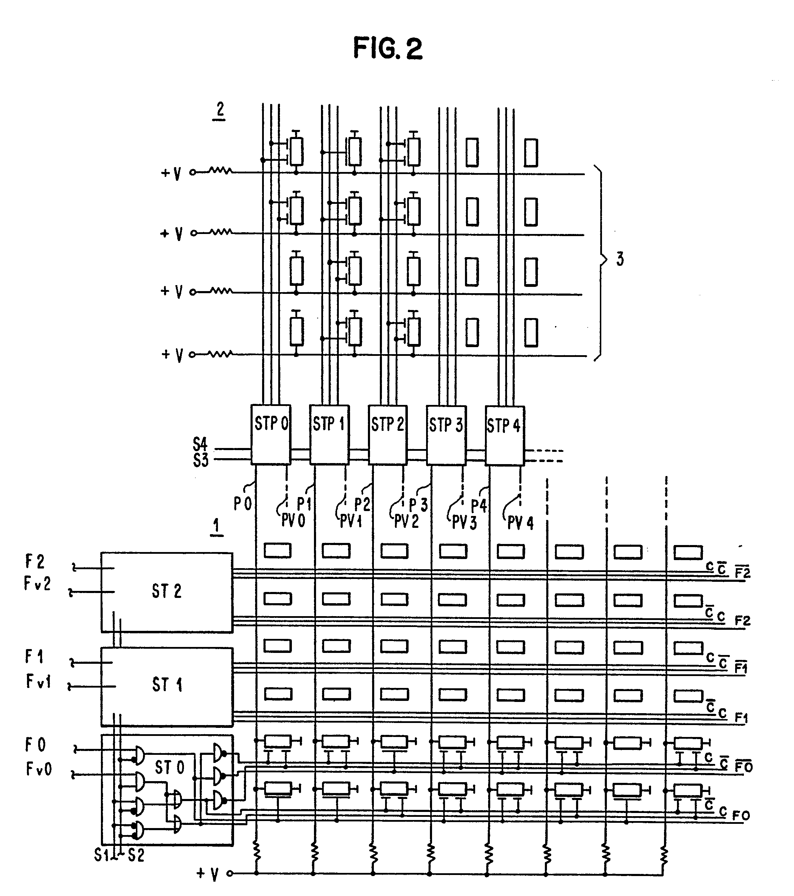

Die in Fig. 1 dargestellte programmierbare logische Schaltungsanordnung eignet sich besonders für die Herstellung in hochintegrierter Technik, da sie sich durch eine regelmässige Struktur auszeichnet und die dazwischenliegenden Steuerschaltungen ebenfalls aus kombinierten UND- und ODER-Schaltungen bestehen. Aufgebaut ist diese programmierbare logische Schaltungsanordnung aus einem UND-Feld 1 und einem ODER-Feld 2, wobei dem UND-Feld 1 Schaltungen ST1 bis Stn zur Selektierung einer der möglichen Zellen vorgeschaltet sind. An jeder durch einen Block dargestellten Steuerschaltung ST1 bis STn liegen gemeinsam die Steuereingänge S1 und S2 und je ein Funktionseingang F1, F2, . . . oder Fn. Die Ausgänge jeder Steuerschaltung ST1 bis STn sind mit F1', C1, C1', . . . Fn', Cn, Cn' bezeichnet. Diese Schaltung zur Selektierung einer der fünf möglichen Zellen innerhalb der programmierbaren logischen Anordnung muss für jeden Funktionsstrang folgende Bedingung erfüllen:

Tabelle 1

| Steuer-eingänge | | Funktions-eingang | PLA-Eingänge | | |
|---|---|---|---|---|---|
| S1 | S2 | Fv | F'v | Cv | C'v |
| 1 | 0 | FKT1 | FKT1 | 1 | 0 |
| 0 | 0 | FKT2 | FKT2 | 0 | 1 |
| 0 | 1 | FKT3 | 0 | FKT3 | FKT3 |

$$F'v = Fv \cdot \overline{S2}$$
$$Cv = Fv \cdot S2 + \overline{S2} \cdot S1$$
$$C'v = Fv \cdot S2 + \overline{S2} \cdot \overline{S1}$$

Das UND-Feld 1 weist Produkt-Termleitungen P1 bis Pm auf, die über Steuerschaltungen STP1 bis STPm sowie deren Ausgangsleitungen P1', C1, C1', . . . Pm', Cm, Cm' auf das ODER-Feld wirken. An den Steuerschaltungen STP1 bis STPm liegen ausserdem die Steuereingänge S3 und S4. An der unteren Kante des ODER-Feldes 2 sind die Ausgänge bzw. Ausgangsleitungen 3 der programmierbaren logischen Anordnung eingezeichnet. Der Aufbau der Steuerschaltungen ST1 bis Stn und STPm wird später anhand der Fig. 2 näher erklärt.

In der Fig. 2 ist nun ein detaillierteres Schaltbild einer programmierbaren logischen Schaltungsanordnung gezeigt, die sich besonders zur Höchstintegration durch die Verwendung von Feldeffekttransistoren mit zwei Torelektroden eignet. Bevor jedoch die Wirkungsweise näher beschrieben wird, soll zunächst der Aufbau und die Wirkungsweise einer einzelnen Zelle nach Fig. 3 beschrieben werden. Eine einzelne Zelle für die hier beschriebene programmierbare logische Schaltungsanordnung besteht aus einem Feldeffekttransistor FET. Dieser Feldeffekttransistor FET besitzt zwei Torelektroden T1 und T2. Die eine Elektrode des Feldeffekttransistors FET, vorteilhafterweise die Drainelektrode, ist über eine Leitung und einen Widerstand R mit einer Spannung V+ verbunden. Ausserdem sind die senkrecht zu dieser Leitung verlaufende Leitung FKT1, 2, die Leitung C und die Leitung C' vorhanden. Die Leitung FKT1, 2 ist die bei der Zweifach-Personalisierung erforderliche Funktionsleitung, wobei für die beiden Funktionen FKT1 und FKT2 folgende Definition gilt:

FKT1: C = 1; C = $\overline{C'}$
FKT2: C = 0; C = $\overline{C'}$.

Die entsprechenden Leitungsverbindungen zu den zwei Elektroden T1 und T2 müssen dieser Tabelle genügen. Wenn man nun den Don't Care-Zustand FKT3 aktivieren will, muss man die in Fig. 3 eingezeichneten Verbindungen zu den Torelektroden T1 und T2 des Feldeffekttransistors des FET herstellen. Diese Verbindungen genügen der folgenden logischen Tabelle zur Aktivierung:

FKT3 = C = C'
FKT1, 2 = 0

Dieser Zustand blieb nämlich bisher bei der zweifachen Personalisierung, wie sie weiter oben beschrieben ist, ungenutzt.

Im folgenden wird nun das in Fig. 2 detailliertere Schaltbild einer programmierbaren logischen Schaltungsanordnung gemäss Fig. 1 näher beschrieben. Die Darstellung gemäss Fig. 2 zeigt die praktische Realisierungsmöglichkeit mit Hilfe von Zellen gemäss Fig. 3 sehr deutlich. Im oberen Teil der Fig. 2 sind die Steuerschaltungen ST0, ST1 und ST2 zu sehen, die mit den gemeinsamen Steuerleitungen S1 und S2 verbunden sind. An den oberen Eingangsleitungen liegen jeweils die Signale Fv0 und F0, Fv1 und F1 sowie Fv2 und F2 an den entsprechenden Steuerschaltungen. Wie aus dem Aufbau der Steuerschaltungen ST0 zu

sehen ist, bestehen die identisch aufgebauten Steuereinheiten ST0, ST1 und ST2 aus UND- und ODER-Schaltungen. An den Ausgängen der Steuerschaltungen stehen die Signal C und $\bar{C}$ sowie F0 und $\overline{F0}$ bei der Steuereinheit ST0 und bei der Steuereinheit ST1, die Signale C und $\bar{C}$ bzw. F1 und $\overline{F1}$ zur Verfügung. An den Ausgängen der Steuerschaltung ST2 stehen die entsprechenden Signale zur Verfügung, wie aus der Fig. 2 hervorgeht. Diese Ausgangssignale führenden Leitungen sind mit den Torelektroden der Zellen des UND-Feldes 1 spaltenweise verbunden, und zwar so, dass jeder Steuerschaltung vorteilhafterweise zwei Spalten, nämlich eine mit der wahren Funktion F0 und die andere mit der negierten Funktion $\overline{F0}$ zugeordnet sind. Als Ausgangsleitungen des UND-Feldes 1 dienen die waagerecht verlaufenden Leitungen P0 bis Pn, von denen jedoch nur fünf in der Fig. 2 dargestellt sind. Diese waagerecht verlaufenden Leitungen P0 bis Pn sind an ihrem anderen Ende über je einen Widerstand mit einem gemeinsamen Anschlusspunkt, an dem eine Spannung +V anliegt, verbunden. Die Ausgangsenden dieser Leitungen P0 bis Pn führen als Eingangsleitungen zu den zwischen dem UND-Feld 1 und dem ODER-Feld 2 liegenden Steuerschaltungen STP0 bis STPn, wobei auch hier wieder nur in Fig. 2 fünf Steuerschaltungen dargestellt sind. Ausserdem sind diese Steuerschaltungen STP0 bis STPn mit Leitungen verbunden, auf denen die Steuersignale S3 und S4 zugeführt werden. Die Eingänge Pv0 ... Pvm können mit beliebigen Produkttermleitungen (P0 ... 8m) zur optimalen Ausnutzung der Don't Care-Position verbunden werden. Die Ausgangsleitungen der Steuerschaltungen STP0 bis STPn sind nun ihrerseits mit den Torelektroden jeweils einer Reihe von Zellen des ODER-Feldes 2 verbunden. Die Zellen des ODER-Feldes 2 bestehen ebenfalls wieder aus einer Grundzelle gemäss Fig. 3. Senkrecht zu den Ausgangsleitungen der Steuerleitungen STP0 bis STPn verlaufen die Summentermleitungen 3 bzw. FKT1, 2 ... der programmierbaren logischen Anordnung, auf denen das logische Ausgangsprodukt nach Vollendung einer Operation erscheint. Das andere Ende dieser Leitungen ist jeweils über einen Widerstand mit einer Spannungsquelle +V verbunden.

Die Steuerschaltungen ST0, ST1 oder ST2 zur Selektierung einer der fünf möglichen Zellenzustände müssen für jeden Funktionsstrang v folgende Bedingungen erfüllen:

| Steuer-eingänge | | Funktions-eingang | PLA-Eingänge | | |
|---|---|---|---|---|---|
| S1 | S2 | Fv | F'v | Cv | C'v |
| 1 | 0 | FKT1 | FKT1 | 1 | 0 |
| 0 | 0 | FKT2 | FKT2 | 0 | 1 |
| 0 | 1 | FKT3 | | FKT3 | FKT3 |

Daraus ergibt sich, $F'v = Fv \cdot \overline{S2}$
$\overline{F'v} = \overline{Fv}$
$Cv = Fvn \cdot S2 + \bar{S} \cdot S1$
$C'v = Fvn \cdot S2 + \overline{S2} \cdot S1$

Diesen soeben angegebenen Funktionen entspricht die Schaltung aus UND- und ODER-Schaltungen, die in der Steuerschaltung ST0 gezeigt ist. Der Aufbau für die Steuerschaltungen ST1 und ST2 ist selbstverständlich analog und auch der zwischen dem UND- und dem ODER-Feld der programmierbaren logischen Anordnung angeordneten Steuerschaltungen STP0 bis STPn ist analog. Zur optimalen Ausnutzung der Don't Care-Zustände einer programmierbaren logischen Schaltungsanordnung kann jeder Funktionseingang Fn auf jeden beliebigen Funktionsstrang der programmierbaren logischen Schaltungsanordnung geschaltet werden.

Im folgenden werden nun Funktionskombinationen angegeben. Durch die separate Ansteuermöglichkeit des UND- und des ODER-Feldes 1 und 2 können somit neun logische Funktionen realisiert werden. Dies geht aus der nachfolgenden Tabelle hervor.

| S1 | S2 | S3 | S4 | Produkt-terme | Summen-terme | Logische Gesamt-funktion |
|---|---|---|---|---|---|---|
| 1 | 0 | 1 | 0 | P1 | S1 | PLA-FKT1 |
| 0 | 0 | 0 | 0 | P2 | S2 | PLA-FKT2 |
| 0 | 1 | 0 | 1 | P3 | S3 | PLA-FKT3 |
| 0 | 0 | 0 | 0 | P1 | S2 | PLA-FKT4 |
| 0 | 0 | 0 | 1 | P2 | S3 | PLA-FKT5 |
| 0 | 1 | 1 | 0 | P3 | S1 | PLA-FKT6 |
| 1 | 0 | 0 | 1 | P1 | S3 | PLA-FKT7 |
| 0 | 0 | 1 | 0 | P2 | S1 | PLA-FKT8 |
| 0 | 1 | 0 | 0 | P3 | S2 | PLA-FKT9 |

Wie bereits ausgeführt worden ist, können die Steuerschaltungen ST1 bis n und STP1 bis n sehr gut in die Struktur der programmierbaren logischen Schaltungsanordnung, die ebenfalls aus UND- und ODER-Schaltungen besteht, integriert werden. Daraus ergibt sich ein relativ kleiner Flächenbedarf für diese Steuerschaltungen, der nicht ins Gewicht fällt.

Je nach Verwendung der programmierbaren logischen Schaltungen differiert die Anzahl der Eingänge, die Anzahl der Leitungen für die Produkterme und die Anzahl der Leitungen für die Summenterme. Bei solchen mit sehr vielen Produkttermen ist die Integration einer zusätzlichen Steuerleitung in das ODER-Feld 2 zu empfehlen. Dadurch reduziert sich die Steuerlogik für das gesamte ODER-Feld 2 auf zwei logische UND-Glieder. Ein weiterer Vorteil ist die dadurch mögliche Dreifachbenutzung der Bits, wodurch für die ODER-Funktion S3 somit nicht nur die Don't Care-Positionen, sondern auch die schon zweifach belegten Positionen benutzt werden können. In Fig. 4 ist nun schematisch ein Teil der programmierbaren logischen Schaltungsanordnung in personalisierter Form dargestellt. Links ist wieder in schematisierter Form das UND-Feld 1 und rechts das ODER-Feld 2 gezeigt. Anstelle der Steuerschaltungen STP0 bis STP4 und ST0 bis ST2 gemäss Fig. 2 sind hier die von diesen Steuerschaltungen an die einzelnen Spaltenleitungen im UND-Feld 1 gelieferten logischen Signale eingezeichnet.

F0, F1, F3 sind dabei die Eingangsoperanden. Wie aus der oberhalb der schematisch dargestellten personalisierten programmierbaren logischen Anordnung dargestellten kleinen Tabelle mit den Zuordnungssymbolen innerhalb des UND-Feldes bzw. des ODER-Feldes 1 bzs. 2 hervorgeht, entsprechen sich hier folgende Ausdrücke:

F0 entspricht A0 mit dem schwarzen Dreieck bzw.
           A0 mit dem weissen Dreieck bzw.
           A mit dem gestrichelten Dreieck,
in den Kreuzungspunkten der senkrecht und waagrecht verlaufenden Leitungen.
F1 entspricht B0 mit dem zugeordneten schwarzen Dreieck bzw.
           A1 mit dem zugeordneten weissen Dreieck bzw.
           B mit dem zugeordneten gestrichelten Dreieck
und F2 entspricht CIN mit dem schwarzen Dreieck bzw.
           A2 mit dem weissen Dreieck.

Fv bedeutet hier «variabler» Eingang. Für die dritte Personalisierungsebene, das sind die Zellen mit den aktivierten Don't Care-Zuständen, können Eingänge wahlweise belegt werden (z.B. F2 auf Fv der Steuerschaltung ST0). Im Anwendungsbeispiel wurde davon Gebrauch gemacht.

Im Nachfolgenden werden für die Funktionen Zweierkomplement, Volladdierer und Decoder die zu implementierenden Funktionen angegeben, wobei zunächst eine Tabelle für die Steuereingänge S1 bis S4 angegeben wird.

| S1 (=S3) | S2 (=S4) | Funktion |
|---|---|---|
| 0 | 0 | 2'er Komplement |
| 1 | 0 | Volladdierer |
| 0 | 1 | Decoder |

1) 2er Komplement einer dreistelligen Binärzahl
Eingang (Binärzahl):       A0, A1, A2
Ausgang (2er Komplement): A0K, A1K, A2K
$A0K = \overline{A2}\,\overline{A1}\,A0 + \overline{A2}\,A1\,A0 + A2\,\overline{A1}\,A0 + A2\,A1\,A0$
$A1K = \overline{A2}\,\overline{A1}\,A0 + \overline{A2}\,A1\,\overline{A0} + A2\,\overline{A1}\,A0 + A2\,A1\,\overline{A0}$
$A2K = A2\,\overline{A1}\,\overline{A0} + \overline{A2}\,A1\,A0 + \overline{A2}\,\overline{A1}\,A0 + \overline{A2}\,A1\,\overline{A0}$

2) 2-Bit Volladdierer
Eingang: A0, B0, Carryin (CIN)
Ausgang: SUM, Carryout (COU)
$SUM = A \oplus B \oplus C = \overline{A}\overline{B}\,C + \overline{A}B\overline{C} + A\overline{B}\overline{C} + ABC$
$COU = C(A \oplus B) + AB = \overline{A}BC + A\overline{B}C + AB\overline{C} + ABC$

3) 2-Bit Decoder
Eingang: A, B
Ausgang: 0, 1, 2, 3

Das Testen der programmierbaren logischen Anordnung kann durch Selektieren der aktivierbaren Don't Care-Positionen in einer zweifach adressierbaren programmierbaren logischen Schaltungsanordnungen erfolgen, wobei folgendes Testprinzip zugrundegelegt wird:

1. Eindeutige Zuordnung der ersten bzw. zweiten Ebene der programmierbaren logischen Anordnung (Personalisierungsebene) des UND-Feldes 1 zur Testebene (Don't Care-Ebene) des ODER-Feldes 2 zum Testen des UND-Feldes 1.

2. Eindeutige Zuordnung der ersten bzw. zweiten Ebene der programmierbaren logischen Schaltungsanordnung des ODER-Feldes 2 zur Testebene des UND-Feldes 1 zum Testen des ODER-Feldes 2.

Dadurch wird jeder Produktterm bzw. Summenterm durch die Selektierung der aktivierbaren Don't Care-Positionen in einer zweifach adressierbaren logischen Schaltungsanordnung getestet.

**Patentansprüche**

1. Programmierbare, hoch integrierte, logische Schaltungsanordnung (PLA), die zur Erhöhung des Ausnutzungsgrades der im UND- (1) und im ODER-Feld (2) vorhandenen Verknüpfungszellen zwischen zwei ausführbaren logischen Funktionen umschaltbar ist, wobei die Verknüpfungszellen aus Feldeffekt-Transistoren bestehen, die an den Kreuzungspunkten der Funktionseingangs- (F, F') und Produkttermleitungen (P, P') im UND-Feld bzw. Produktterm- (P, P') und Summentermleitungen (3) im ODER-Feld angeordnet sind und wobei im UND- und im ODER-Feld Steuerleitungen (C, C') zur Funktionsumschaltung vorgesehen sind, dadurch gekennzeichnet, dass die Feldeffekt-Transistoren jeweils zwei Torelektroden aufweisen, dass den Eingängen des UND-Feldes und des ODER-Feldes Steuerschaltungen (ST bzw. STP) zur Funktionsumschaltung vorgeschaltet sind, von denen parallel zu den Funktionseingangs- (F') bzw. Produkttermleitungen (P') mehrere Steuerleitungen (C, C') ausgehen, dass für die genannten zwei Funktionen, die eine Torelektrode des jeweiligen Feldeffekt-Transistors jeder personalisierten Verknüpfungszelle mit der Funktionseingangs- bzw. Summentermleitung und die andere Torelektrode mit einer Steuerleitung und die andere Torelektrode mit einer Steuerleitung verbunden ist, und dass zur Ausführung einer dritten logischen Funktion beide Torelektroden des Feldeffekt-Transistors von für die genannten zwei Funktionen nicht verwendeten Verknüpfungszellen mit je einer Steuerleitung verbunden sind, wobei durch die Steuerschaltungen zur Umschaltung auf die dritte logische Funktion die Funktionseingangs- (F') bzw. Produkttermleitungen (P') abgeschaltet werden und die zugehörigen Bits statt dessen gleichzeitig auf die Steuerleitungen (C, C') gegeben werden.

2. Programmierbare, hoch integrierte, logische Schaltungsanordnung (PLA) nach Anspruch 1, dadurch gekennzeichnet, dass die Steuerschaltungen (ST bzw. STP) in das UND- (1) und/oder das ODER-Feld (2) voll integriert sind.

3. Programmierbare, hoch integrierte, logische Schaltungsanordnung nach den Ansprüchen 1 und 2, dadurch gekennzeichnet, dass bei Beibehaltung des Eingangs-Bitmusters (z.B. Operationscode einer Instruktion) in Abhängigkeit von Signalen auf den Steuerleitungen (S1, S2) drei verschiedene Ausgangsgrössen erzeugbar sind.

4. Programmierbare, hoch integrierte, logische Schaltungsanordnung nach einem der Ansprüche 1 bis 3, dadurch gekennzeichnet, dass eine Ebene des ODER-Feldes (2) als Testebene für das UND-Feld (1) dient und dass eine Ebene des UND-Feldes (1) als Testebene für das ODER-Feld (2) dient.

5. Programmierbare, hoch integrierte, logische Schaltungsanordnung nach den Ansprüchen 1 bis 4, dadurch gekennzeichnet, dass alle Steuerschaltungen (ST bzw. STP) identisch aufgebaut sind.

**Claims**

1. Programmable, highly integrated logic circuit arrays (PLA) which can be switched to intensify the degree of utilization of the logic cells existing in the AND (1) and in the OR field (2) between two executable logic functions, the logic cells consisting of field effect transistors which are arranged at the intersections of the functional input (F, F′) and product term lines (P, P′) in the AND field, and the product term (P, P′) and sum term lines (3) in the OR field, and control lines (C, C′) being provided in the AND and in the OR field for functional switching, characterized in that the field effect transistors each comprise two gate electrodes, that control circuits (ST, and STP) respectively being arranged in series to the inputs of the AND field and of the OR field for functional switching, several control lines (C, C′) being provided therefrom in parallel to the functional input (F′) or product term lines (P′), that for the above mentioned two functions the one gate electrode of the respective field effect transistor of each personalized logic cell is connected to the functional input or sum term line, respectively, and the other gate electrode to a control line, and that for implementing a third logic function both gate electrodes of the field effect transistor of logic cells not used for the above two functions are connected to one respective control line each, the control circuits, for switching to the third logic function, switching off the function input (F′) and product term lines (P′), and the associated bits being simultaneously applied to the control lines (C, C′) instead.

2. Programmable, highly integrated logic circuit arrays (PLA) as claimed in claim 1, characterized in that the control circuits (ST or STP), respectively are fully integrated in the AND (1) and/or the OR field (2).

3. Programmable, highly integrated logic circuit array as claimed in claims 1 and 2, characterized in that if the input bit pattern (e.g. operational code of an instruction) is maintained as a function of signals on the control lines (S1, S2) three different output quantities can be generated.

4. Programmable, highly integrated logic circuit array as claimed in any one of claims 1 to 3, characterized in that one plane of the OR field (2) is used as a test plane for the AND field (1), and that one plane of the AND field (1) is used as a test plane for the OR field (2).

5. Programable, highly integrated logic circuit array as claimed in any one of claims 1 to 4, characterized in that all control circuits (ST and STP), respectively, are identically structured.

**Revendications**

1. Réseau logique programmable à haut degré d'intégration (PLA) qui, pour augmenter le degré d'utilisation de la capacité des éléments logiques prévus dans le panneau ET (1) et dans le panneau OU (2), peut être commuté entre deux fonctions logiques exécutables, les éléments logiques étant constitués par des transistors à effet de champ qui sont installés aux points de croisement des lignes d'entrées de fonctions (F, F′) et des lignes des termes de produits (P, P′) dans le panneau ET ainsi que des lignes de termes de produits (P, P′) et des lignes des termes de sommes (3) dans le panneau OU et dans lequel des lignes de commande (C, C′) pour la commutation des fonctions sont prévues dans le panneau ET et dans le panneau OU, caractérisé par le fait que les transistors à effet de champ comportent respectivement deux portes, qu'en amont des entrées du panneau ET et du panneau OU sont montés des circuits de commande (ST, STP) pour la commutation des fonctions et desquels partent, parallèlement aux lignes d'entrées des fonctions (F′) et des lignes des termes de produits (P′), plusieurs lignes de commande (C, C′), que pour les deux fonctions citées une porte du transistor à effet de champ à chaque fois considéré de chaque élément logique personnalisé est raccordée à la ligne d'entrée des fonctions et à la ligne des termes de sommes et l'autre porte à une ligne de commande, et que pour l'exécution d'une troisième fonction logique, les deux portes du transistor à effet de champ des éléments logiques non utilisés pour les deux fonctions citées sont respectivement raccordées à une ligne de commande, les lignes d'entrées de fonctions (F′) et les lignes des termes de produits (P′) étant coupées spar les circuits de commande pour la commutation à la troisième fonction logique et les bits correspondants étant à la place envoyés simultanément aux lignes de commande (C, C′).

2. Réseau logique programmable à haut degré d'intégration (PLA) selon la revendication 1, caractérisé par le fait que les circuits de commande (ST et STP) sont entièrement intégrés dans le panneau ET (1) et/ou le panneau OU (2).

3. Réseau logique programmable à haut degré d'intégration selon les revendications 1 et 2, caractérisé par le fait que, tout en maintenant la structure binaire d'entrée (par exemple code d'opération d'une instruction), trois grandeurs de sortie différentes peuvent être obtenues en fonction des signaux apparaissant sur les lignes de commande (S1, S2).

4. Réseau logique programmable à haut degré d'intégration selon l'une des revendications 1 à 3, caractérisé par le fait qu'un plan du panneau OU (2) sert de plan d'essai pour le panneau ET (1) et qu'un plan du panneau ET (1) sert de plan d'essai pour le panneau OU (2).

5. Réseau logique programmable à haut degré d'intégration selon les revendications 1 à 4, caractérisé par le fait que tous les circuits de commande (ST et STP) sont de structure identique.

FIG. 1

F1  Fn

S1
S2  ST1 ... STn  S3  S4

STP 1

F1' C1'  Fn' Cn'  P1  P1'
C1           Cn        C1'
                        C1'

1                    2

Pm  Pm'
      Cm'
      Cm'

STPm

3

FIG. 3

+V  R  FKT1,2  C  C'  FKT 1,2/3

T1
T2  FET

FIG. 4

| A0 | $\overline{A0}$ | B0 | $\overline{B0}$ | CIN | $\overline{CIN}$ | ≙ |
| A2 | $\overline{A2}$ | A1 | $\overline{A1}$ | A0 | $\overline{A0}$ | ≙ |
| A | $\overline{A}$ | B | $\overline{B}$ | | | ≙ |

1

2

A2K  A1K  A0K
      SUM  COU
2  0  1  3

9

# FIG. 2